Europäisches Patentamt

European Patent Office

Office européen des brevets

(19)

(11) Veröffentlichungsnummer: **0 313 131**
**A2**

(12) **EUROPÄISCHE PATENTANMELDUNG** .

(21) Anmeldenummer: 88202193.4

(22) Anmeldetag: 04.10.88

(51) Int. Cl.4: **H05K 7/14 , H05K 9/00**

(30) Priorität: **20.10.87 DE 3735456**

(43) Veröffentlichungstag der Anmeldung:
**26.04.89 Patentblatt 89/17**

(84) Benannte Vertragsstaaten:
**DE FR GB IT**

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB IT**

(72) Erfinder: **Peyerl, Gerhard**
**Kaiserstrasse 42**
**D-8500 Nürnberg 1(DE)**

(74) Vertreter: **Peuckert, Hermann, Dipl.-Ing. et al**
**Philips Patentverwaltung GmbH**
**Wendenstrasse 35 Postfach 10 51 49**
**D-2000 Hamburg 1(DE)**

(54) **Aufnahmevorrichtung mit geschirmten Leiterplatten.**

(57) Aufnahmevorrichtungen sind zur Aufnahme von Leiterplatten an zwei gegenüberliegenden Innenseiten mit Führungsnuten versehen, in welche die Leiterplatten mit ihren Rändern eingeschoben werden.

Sind die Leiterplatten in einem allseitig geschlossenen Schirmgehäuse eingesetzt, das außen Führungsstege trägt, welche in Nuten eines Aufnahmerahmens geführt sind, so müssen bei einer gleichmäßigen Ausführung des Aufnahmerahmens die Leiterplatten unterschiedliche Abmessungen haben, je nachdem, ob sie in einem Schirmgehäuse eingesetzt sind oder nicht.

Die Aufnahmevorrichtung mit eingesetztem Schirmgehäuse ist so ausgestalten, daß ohne Abwandlung der Abmessungen der Gestelle oder Aufnahmerahmen Leiterplatten der sonst hierfür gebräuchlichen Größe in einem geschlossenen Schirmgehäuse einsetzbar sind.

Es wird vorgeschlagen, die Führungsmittel in der Aufnahmevorrichtung als Stege und die Führungsmittel am Schirmgehäuse als Nuten auszubilden.
Einrichtungen der Nachrichtentechnik.

FIG.1

## Aufnahmevorrichtung mit geschirmten Leiterplatten

Die Erfindung betrifft eine Aufnahmevorrichtung mit Leiterplatten in Schirmgehäusen, die an zwei gegenüberliegenden Seitenwänden innen Nuten für die Aufnahme von wenigstens einer Leiterplatte und außen Führungsmittel aufweisen, welche mit entsprechenden Führungsmitteln in der Aufnahmevorrichtung zusammenwirken. Solche geschirmte Leiterplatten sind in der elektrischen Nachrichtentechnik gebräuchlich, die Aufnahmevorrichtungen können z.B. Gerätegehäuse oder Gestelle sein, in welchen eine Vielzahl solcher geschirmter Leiterplatten unterbringbar ist.

Es ist bekannt, Aufnahmevorrichtungen zur Aufnahme von Leiterplatten an zwei gegenüberliegenden Innenseiten mit Führungsnuten zu versehen, in welche als bestückte Leiterplatten ausgebildete Baugruppen mit ihren Rändern eingeschoben werden können. Die Ränder der Leiterplatten bilden in diesem Fall an zwei einander gegenüberliegenden Seiten angeordnete Führungsmittel. Es ist ferner bekannt, solche Leiterplatten zur Abschirmung auf beiden Seiten mit Abschirmkappen aus Metall zu versehen, wobei die eine Abschirmkappe die Lötseite und die andere Abschirmkappe die Bauelementeseite abdeckt. Die Ränder der Leiterplatte bleiben dabei frei und sind auch in dieser geschirmten Ausführungsform als Führungsmittel verwendbar. Die Fertigung von zwei gesonderten Abschirmkappen und deren Anbringen auf jeweils einer Leiterplattenseite ist jedoch kostenaufwendig.

Es ist aus DE-PS 27 47 894 ferner bekannt, zur Verbesserung der Abschirmung ein geschlossenes aus Metall gefertigtes Gehäuse vorzusehen, welches an gegenüberliegenden Innenseiten Nuten aufweist, in welche die Leiterplatte eingeschoben werden kann. An zwei gegenüberliegenden Wänden der auf diese Weise gebildeten Flachbaugruppe befinden sich außen Führungsstege, welche in entsprechend geformten Nuten in einem Gestell oder in einem Aufnahmerahmen geführt sind. Werden in der gleichen Aufnahmevorrichtung sowohl ungeschirmte Leiterplatten wie auch geschirmte Flachbaugruppen vorstehend geschilderter Bauweise eingesetzt, so ergibt sich, daß bei einer gleichmäßigen Ausführung des Aufnahmerahmens die Leiterplatten unterschiedliche Abmessungen haben müssen, je nachdem, ob sie in einem Schirmgehäuse eingesetzt sind oder nicht. Bei der Leiterplattenherstellung haben sich jedoch bestimmte Normmaße herausgebildet, z.B. das sog. "Europakartenformat". Entsprechend diesen Normmaßen sind die Abstände zwischen den Leiterplattenführungsebenen in den Gestellen und Aufnahmerahmen bemessen. Eine Verkleinerung der verfügbaren Leiterplattenoberfläche gegenüber dem Normmaß ist auch deshalb unerwünscht, weil hierdurch die Aufnahmekapazität der Leiterplatte eingeschränkt wird.

Der Erfindung liegt die Aufgabe zugrunde, eine Einrichtung der eingangs Art so auszugestalten, daß ohne Abwandlung der Abmessungen der Gestelle oder Aufnahmerahmen Leiterplatten der sonst hierfür gebräuchlichen Größe in einem geschlossenen Schirmgehäuse einsetzbar sind.

Diese Aufgabe wird gemäß der Erfindung dadurch gelöst, daß die Führungsmittel in der Aufnahmevorrichtung Stege und die Führungsmittel am Schirmgehäuse Nuten sind. Eine Weiterbildung der Erfindung wird darin gesehen, daß das Schirmgehäuse aus Blech besteht und die Nuten durch Einprägungen gebildet sind. Ein derart ausgebildetes Schirmgehäuse ist besonders kostengünstig zu fertigen, da für die Nuten keine gesonderten Teile erforderlich sind.

Eine weitere Verbesserung besteht darin, daß die Aufnahmevorrichtung aus Blech geformte Querträger mit mehreren parallelen Stegen aufweist, wobei die Stege aus der Blechoberfläche freigestanzte und rechtwinklig umgebogene Blechstreifen sind.

Im folgenden soll die Erfindung anhand eines in den Fig. 1 bis 3 dargestellten Ausführungsbeispieles näher beschrieben und erläutert werden.

Es zeigt in schematischer Darstellung:

Fig. 1 eine Schrägansicht eines Ausschnittes einer Aufnahmevorrichtung mit einer eingesetzten geschirmten Leiterplatte,

Fig. 2 einen Querträger mit Führungssteg,

Fig. 3 einen Querträger mit Führungsnut,

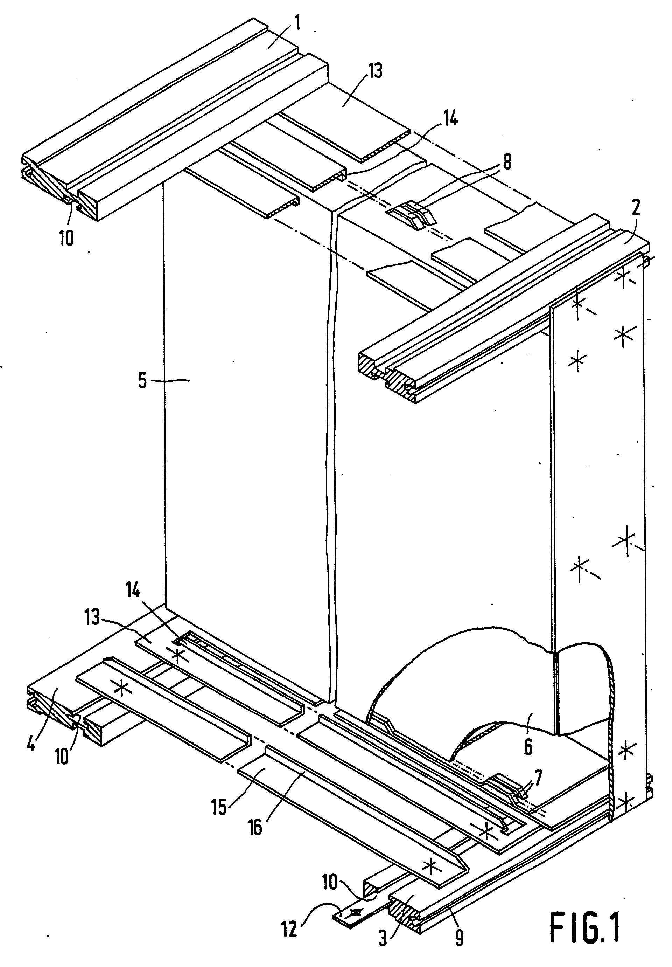

In der in Fig. 1 gezeigten schematischen Darstellung eines Ausschnittes einer Aufnahmevorrichtung für Leiterplatten in Schirmgehäusen sind obere Holme 1 und 2 sowie untere Holme 3 und 4 gezeigt, aus denen die Aufnahmevorrichtung aufgebaut ist. Die Holme sind in bekannter Weise seitlich an einem Rahmengestell oder in einem Gehäuse befestigt. Sie sind vorzugsweise als Strangpressprofile ausgebildet und tragen sowohl an Breit- wie an Schmalseiten T-förmige Nuten. In den an den Breitseiten der Holme 1 bis 4 verlaufenden T-förmigen Nuten 10 sind zwischen je zwei Holmen Querträger befestigbar, welche Führungsmittel tragen. In Fig. 1 sind zwei verschiedene Ausführungsformen solcher Querträger dargestellt. Als erste Ausführungsform ist eine Führungsebene vorgesehen, die aus einem in als flaches Blechteil ausgebildeten Querträger 13 besteht, welcher mittels Schrauben an in den T-förmigen Nuten eingesetzen Blechstreifen 12 mit Gewindelöchern festschraubbar ist. Anstelle eines Blechstreifens mit Gewindelöchern sind auch einzelne Schiebemuttern verwendbar. Dieser Querträger 13 trägt als Führungsmittel mehrere parallele Stege 14, welche in einfacher Weise durch Freistanzen eines Blechstreifen und Umbiegen dieses Blechstreifens aus der Oberfläche des Querträgerbleches hergestellt werden können. Diese Ausführungsform hat den Vorteil, daß zur Befestigung einer Vielzahl von Stegen nur wenig Befestigungsmittel notwendig sind, daß ferner bei der Montage der Stege besondere Lehren zur Einhaltung definierter Abstände der Führungsmittel voneinander entbehrlich sind und daß dennoch beim Einsatz moderner numerisch gesteuerter Stanzmaschinen ohne Aufwand für besondere Werkzeuge Querträger herstellbar sind, bei denen die Stege unterschiedliche Abstände aufweisen.

Eine andere Ausführungsform der Querträger besteht darin, daß als Querträger ein schmaler Blechstreifen 15 verwendet ist, dessen eine Längsseite rechtwinklig umgebogen ist, so daß ein langgestreckter Blechwinkel entsteht, dessen einer Schenkel den Steg 16 als Führungsmittel bildet. Dieser Blechstreifen 15 ist ebenfalls mittels Schrauben an in den T-förmigen Nuten geführten Blechstreifen 12 mit Gewindelöchern (Gewindeschienen) oder einzelnen Schiebemuttern anschraubbar. Auch diese Ausführungsform ist sehr einfach und kostengünstig herstellbar.

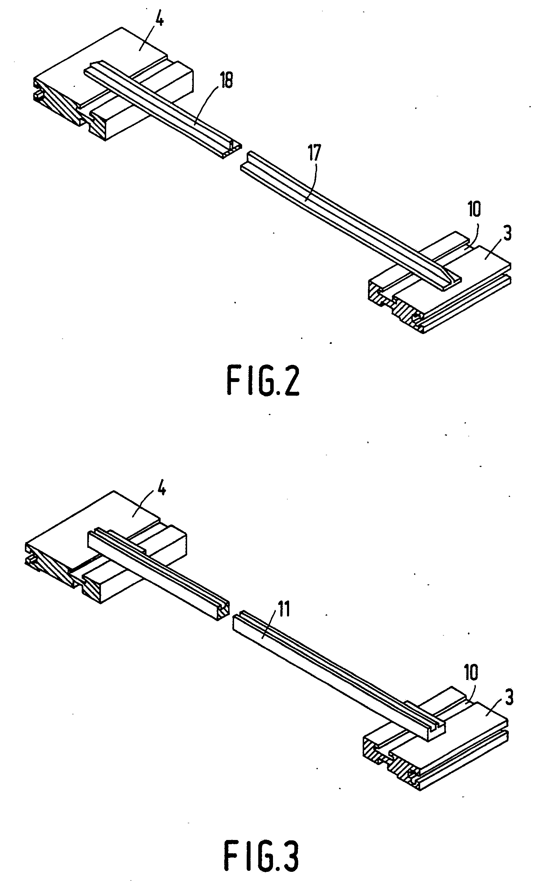

Eine weitere vorteilhafte Ausführungsform eines Querträgers mit Steg ist in Fig. 2 gezeigt. Sie besteht aus einem schmalen Trägerteil 17, welches vorzugsweise aus Kunststoff gefertigt ist und mittels entsprechenden Rastnasen an seiner Unterseite in die T-förmigen Nuten 10 einschnappbar ist. An seiner Oberseite trägt es als Führungsmittel einen Steg 18. Diese Ausführungsform hat ebenso wie die vorerwähnte Ausführungsform den Vorteil, daß die Abstände der Querträger 15 voneinander je nach der Breite der einzusetzenden Baugruppen beim Zusammenstellen einer Aufnahmevorrichtung für einen bestimmten Zweck beliebig bestimmbar sind.

Fig. 3 zeigt ein Querträger 11, welcher in bekannter Weise als Führungsmittel eine Nut aufweist, so daß eine Leiterplatte mit ihrer Kante darin führbar ist. Dieser Querträger 11 mit Nut ist ebenfalls mit entsprechenden Rastmitteln in den T-förmigen Nuten 10 der Holme 3 und 4 einschnappbar.

Das Schirmgehäuse 5 für die Leiterplatte 6 ist aus Blech geformt. Die Frontplatte ist an einem an der Vorderkante der Leiterplatte angebrachten Winkelblech befestigt und ist höher als das Schirmgehäuse selbst, so daß sie sowohl oben als auch unten über die Außenabmessungen des Schirmgehäuses hinausragt. Mit diesen überragenden Abschnitten der Frontplatte ist diese an der Vorderseite der Holme 2 bzw. 4 in T-förmigen Nuten 9 gehaltenen Gewindeschienen oder Schiebemuttern angeschraubt.

Der Abstand zwischen den oberen Holmen 1 und 2 und den unteren Holmen 3 und 4 ist so bemessen, daß Leiterplatten in einer bestimmten Größe, z.B. im sogenannten Europakartenformat, eingeschoben werden können, wenn als Führungsmittel in üblicher Weise Nuten tragende Querträger an den Holmen befestigt sind. Ohne Veränderung des Abstandes der Holme voneinander ist der Einsatz von Leiterplatten der gleichen Größe in Schirmgehäusen möglich, wenn die vorstehend beschriebenen als Steg ausgebildeten Führungsmittel verwendet sind. Das Schirmgehäuse 5 ist an gegen überliegenden Außenseiten mit Nuten versehen. Diese bestehen, wie im Ausführungsbeispiel Fig. 1 gezeigt, aus parallelen Einprägungen 8, zwischen denen der Steg 14 geführt ist. Zur Führung der Leiterplatte 6 im Schirmgehäuse 5 sind an gegenüberliegenden Innenseiten ebenfalls parallele Einprägungen 7 vorgesehen. Solche Einprägungen lassen sich in Blechmaterial mittels numerisch gesteuerter Stanz- und Nibbelmaschinen mit hoher Genauigkeit schnell und kostengünstig erzeugen. Die Lage der durch die Einprägungen gebildeteten Nuten kann daher abhängig von der Bestückung der Leiterplatte bzw. für jedes Schirmgehäuse gesondert ohne besonderen Aufwand an Werkzeug beliebig variiert werden.

Infolge der Anordnung von nach außen weisenden Einprägungen zur Führung des Schirmgehäuses sowie von nach innen weisenden Einprägungen zur Führung der Leiterplatte im Schirmgehäuse ist der Unterschied der Kantenabmessungen zwischen ungeschirmter Leiterplatte und Schirmgehäuse mit Leiterplatte außerordentlich gering.

Ein weiterer Vorteil besteht darin, daß in der gleichen Aufnahmevorrichtung Querträger herkömmlicher Art mit Nuten und Querträger mit Stegen kombinierbar sind, so daß in der gleichen Aufnahmevorrichtung sowohl Leiterplatten in geschlossenen Schirmgehäusen als auch ungeschirmte Leiterplatten gleicher Größe einsetzbar sind.

## Ansprüche

1. Aufnahmevorrichtung mit Leiterplatten in Schirmgehäusen, die an zwei gegenüberliegenden Seitenwänden innen Nuten für die Aufnahme von wenigstens einer Leiterplatte und außen Führungsmittel aufweisen, welche mit entsprechenden Führungsmitteln in der Aufnahmevorrichtung zusammenwirken, dadurch gekennzeichnet, daß die Führungsmittel in der Aufnahmevorrichtung Stege (14, 16) und die Führungsmittel am Schirmgehäuse Nuten (8) sind.

2. Aufnahmevorrichtung nach Anspruch 1, dadurch gekennzeichnet, daß das Schirmgehäuse aus Blech besteht und die Nuten (8) durch Einprägungen gebildet sind.

3. Aufnahmevorrichtung nach Anspruch 1 oder Anspruch 2, dadurch gekennzeichnet, daß in der Aufnahmevorrichtung zwei gegenüberliegende Führungsebenen vorgesehen sind, daß die Führungsebenen aus Blech geformte Querträger (13) sind und eine Mehrzahl von Stegen (14) tragen, welche aus der Blechoberfläche freigestanzte und rechtwinkelig umgebogene Blechstreifen sind.

4. Aufnahmevorrichtung nach Anspruch 1 oder Anspruch 2, dadurch gekennzeichnet, daß Querträger (15) mit jeweils nur einem Steg (16) vorgesehen sind, welche als langgestreckte Blechwinkel ausgebildet sind, wobei ein Schenkel des Blechwinkels der Steg (16) ist.

5. Aufnahmevorrichtung nach Ansprüchen 1 oder 2, dadurch gekennzeichnet, daß Querträger (17) mit jeweils nur einem Steg (18) vorgesehen sind, welche als langgestreckte Kunststoffteile ausgebildet sind, die an ihrer Unterseite Mittel zum Befestigen in T-förmigen Nuten (10) und an ihrer Oberseite einen Steg (18) aufweisen.

FIG.1

FIG.2

FIG.3